# EUROPEAN PATENT APPLICATION

(11) **EP 2 757 581 A1**
(43) Date of publication of application: **23.07.2014**
(21) Application number: 13192567.9
(22) Date of filing: 12.11.2013
(51) Int. Cl.: H01L 21/84, H01L 27/12, H01L 21/762

(54) **Semiconductor device**

(30) Priority: 22.01.2013 EP 13152160
(71) Applicant: NXP B.V., 5656 AG Eindhoven (NL)
(72) Inventor: Spaan, Erik, Redhill, Surrey RH1 1SH (GB); Van Dalen, Rob, Redhill, Surrey RH1 1SH (GB); Boos, Priscilla, Redhill, Surrey RH1 1SH (GB)
(74) Representative: Hardingham, Christopher Mark

(57) **Abstract**

There is disclosed a semiconductor device. The device comprises: a silicon layer; a tapered insulating layer formed on the silicon layer; and a plurality of Bipolar CMOS DMOS device layers formed above the tapered insulating layer. The taper of the tapered insulating layer is in the lower surface of the tapered insulating layer. The tapered insulating layer has a substantially planar upper surface and is at least partially recessed in the silicon layer.

## Description

This invention relates to semiconductor devices. More particularly, the invention relates to Bipolar CMOS DMOS (BCD) semiconductor devices.

Bipolar CMOS DMOS (BCD) process technology incorporates analog components (Bipolar, CMOS, DMOS), digital components (CMOS) and high-voltage transistors (DMOS) on the same die.

A primary driver of BCD process technology growth has been the recent rise of smartphones and tablets. These devices comprise multiple functions which all compete for power, such as the application processor, baseband processor, the large displays, etc. Such a device thus typically uses one or more Power Management Integrated Circuit (PMIC) chips to manage the power with minimal losses to ensure long battery life.

An evolving application highly suitable for BCD process technology is motor-control, which is used in Hard Disk Drives (HDDs) to turn the spindles for example. High-density BCD process technology can be used along with a modern 32-bit microcontroller to implement sophisticated motor-control System-on-Chips (SoCs) that can implement advanced algorithms to help motors deliver the same or greater output whilst consuming less power.

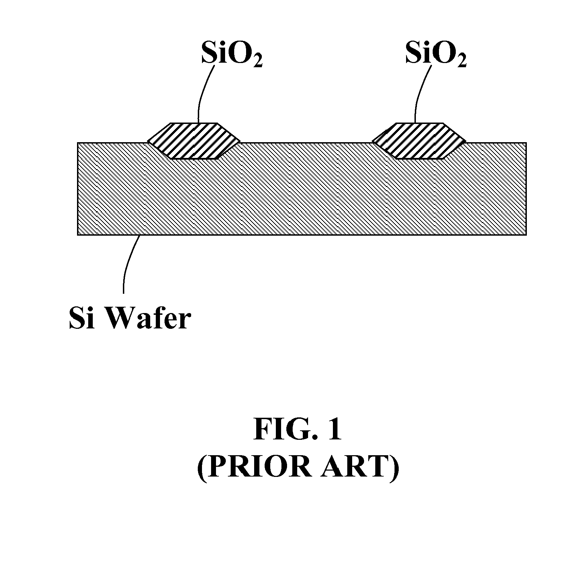

To address the demand for much denser CMOS logic, starting from BCD process technology, the Local Oxidation of Silicon (LOCOS) fabrication process has been developed to insulate MOS transistors from each other. LOCOS is a microfabrication process where a silicon dioxide (SiO₂) insulating structure is formed on a silicon (Si) wafer such that the SiO₂ insulating structure penetrates the surface of the wafer causing the Si-SiO₂ interface to occur at a lower point than the rest of the Si wafer surface (as illustrated in Figure 1). For this, thermal oxidation of selected regions is typically used. The oxygen penetrates in the depth of the wafer, reacts with silicon and transforms it in to SiO₂. In this way, a semi-recessed structure is formed.

BCD processes typically employ: low-temperature constraints; and Shallow Trench Isolation (STI) or thin insulating structures (e.g. SIO₂) produced using a LOCOS process.

Conversely, High Voltage (HV) devices typically make use of: thick insulating structures (e.g. SIO₂) produced using a LOCOS process; the Reduced Surface (Resurf) effect; and High-temperature constraints.

Such contradictory conditions make it difficult to include a HV device within a BCD product (e.g. on a die manufactured using a BCD process).

There is proposed a semiconductor device comprising: a silicon layer; a tapered insulating layer formed on the silicon layer; and a plurality of Bipolar CMOS DMOS device layers formed above the tapered insulating layer, wherein the taper of the tapered insulating layer is in the lower surface of the tapered insulating layer, and wherein the tapered insulating layer has a substantially planar upper surface and is at least partially recessed in the silicon layer.

Embodiments may provide a BCD semiconductor device having a tapered insulating layer portion that is recessed in a silicon layer portion. The tapered insulating layer portion may be more recessed (e.g. recessed to a greater extent) than for conventional LOCOS processing. For a conventional LOCOS processing, the percentage thickness of the oxide portion below the original interface is typically 44% or less, and the percentage thickness of oxide portion above the original interface is therefore typically 56% or more. Conversely, in embodiments, 50% or more of the thickness of the insulating layer may be recessed below the original interface.

The tapered insulating layer may be combined with a plurality of BCD device layers.

The tapered insulating layer portion may be formed using a LOCOS process so as to be recessed in a silicon layer portion. In such embodiments, the tapered insulating structure may extend downwardly into the silicon layer portion so as to have an interface with the silicon layer portion at a lower point than the rest of the silicon layer upper surface. Put another way, the tapered insulating layer portion may extend downwardly into the silicon layer so that, in a first area, the silicon layer is thicker than the tapered insulating layer and so that, in a second area, the tapered insulating layer is thicker than the silicon layer.

Embodiments may provide an advanced BCD device to support HV functionality. Accordingly, embodiments may be used for HV applications using large digital and analog content and HV content.

By way of example, Low Voltage (LV) CMOS/DMOS is typically considered to refer to drain-to-source voltages (Vds) up to 12V.

Medium Voltage (MV), is typically understood to refer to Vds in the range of 12-24V.

HV and Extra High Voltage (EHV) with conventional LOCOS construction, is typically understood to refer to drain-to-source voltages (Vds) in the range of 50V and 120V, respectively. Thus, HV according to proposed embodiments may be higher than 60V, preferably higher than 120V, more preferably higher than 500V, even more preferably higher than 750V, and yet more preferably in excess of 800-900V (as has been demonstrated in tests).

Embodiments may therefore be used for applications where a drain-to-source voltage (Vds) is from an estimated 50V up to (and even in excess of) 900V.

Devices made according to an embodiment may therefore be used for applications connected to mains voltage (e.g. 110V, 220V with voltage spikes due to circuit topology/application), for instance notebook adapters, phone adapters or lighting applications (CFL/LED).

According to an aspect of the invention, there is provided a method of manufacturing a semiconductor device, the method comprising the steps of: forming a tapered insulating layer on a silicon layer; and forming a plurality of Bipolar CMOS DMOS device layers above the tapered insulating layer, wherein the insulating layer is formed such that its taper is in its lower surface, the upper surface is substantially planar, and the tapered insulating layer is at least partially recessed in the silicon layer portion.

There is proposed a concept for manufacturing a semiconductor device having a tapered insulating layer that is recessed in the silicon layer such that more than 44% of the insulating layer's thickness is below the original interface of the silicon layer. The manufacturing method may employ a BCD process.

Embodiments may propose undertaking HV processing steps prior to undertaking LV BCD processing steps so as to reduce or minimise any changes to a LV device formed using the BCD processing steps. Embodiments may thus complete processing steps having high-temperature constraints (such as high temperature anneals and the creation of thick insulating structures using a LOCOS process, for example) before undertaking BCD processes.

The insulating layer may be recessed and have a substantially planar upper surface for trench isolation to be formed using a BCD process. The insulating layer may provide for improved oxide quality and a tapered oxide edge. Such a tapered oxide layer may be beneficial for electrical field distribution and reliability.

The formation of a thick recessed isolation structure (using a LOCOS process for example) together with a buried oxide may enable improved control over the thickness of a thin Silicon-on-Insulator (SOI) layer between the source and drain of a transistor. Such a thin SOI layer may provide a higher critical electric field compared to a conventional SOI layer created using STI.

Examples of the invention will now be described in detail with reference to the accompanying drawings, in which:
Figure 1 illustrates a semi-recessed insulating structure formed using a LOCOS process;
Figures 2-11 illustrate a process for manufacturing a semiconductor device according to an embodiment of the invention;
Figure 12 depicts a cross sectional view of a HV semiconductor transistor according to an embodiment of the invention;
Figure 13 depicts a cross sectional view of a HV junction gate field-effect transistor according to an embodiment of the invention;
Figure 14 depicts a cross sectional view of a HV diode according to an embodiment of the invention; and
Figure 15 depicts a cross sectional view of a Lateral Insulated-Gate Bipolar Transistor according to an embodiment of the invention.

The terms, chip, integrated circuit, monolithic device, semiconductor device, and microelectronic device, are often used interchangeably in this field. The present invention is applicable to all the above as they are generally understood in the field.

The terms metal line, interconnect line, trace, wire, conductor, signal path and signalling medium are all related. The related terms listed above, are generally interchangeable, and appear in order from specific to general. In this field, metal lines are sometimes referred to as traces, wires, lines, interconnect or simply metal. Metal lines, generally aluminum (Al), copper (Cu) or an alloy of Al and Cu, are conductors that provide signal paths for coupling or interconnecting, electrical circuitry. Conductors other than metal are available in microelectronic devices. Materials such as doped polysilicon, doped single-crystal silicon (often referred to simply as diffusion, regardless of whether such doping is achieved by thermal diffusion or ion implantation), titanium (Ti), molybdenum (Mo), and refractory metals are examples of other conductors.

The terms contact and via, both refer to structures for electrical connection of conductors at different interconnect levels. These terms are sometimes used in the art to describe both an opening in an insulator in which the structure will be completed, and the completed structure itself. For purposes of this disclosure contact and via refer to the completed structure.

The term vertical, as used herein, means substantially orthogonal to the surface of a substrate. The term lateral, as used herein, means substantially parallel to the surface of a substrate. Also, terms describing positioning or location (such as above, below, top, bottom, etc.) are to be construed in conjunction with the orientation of the structures illustrated in the diagrams.

The diagrams are purely schematic and it should therefore be understood that the dimensions of features are not drawn to scale. Accordingly, the illustrated thickness of any of the layers should not be taken as limiting. For example, a first layer drawn as being thicker than a second layer may, in practice, be thinner than the second layer.

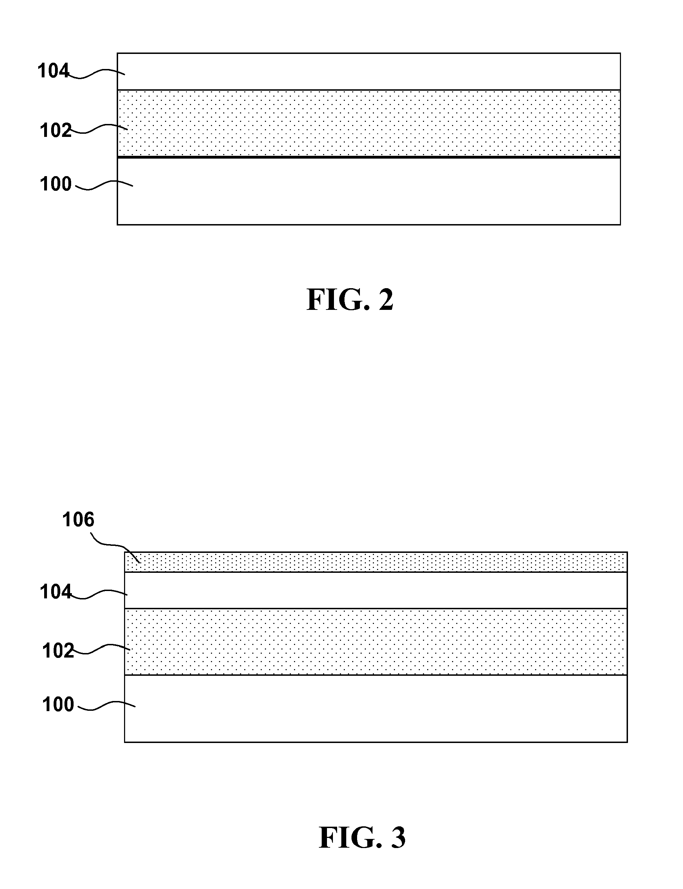

FIG. 2 shows a substrate 100, typically comprised of silicon, with an oxide (i.e. insulator) layer 102 formed thereon. Later, this oxide layer 102 will be referred to as a buried oxide layer 102 due to its resultant position in the formed structure. Formed on top of (and covering) the oxide layer 102, there is a silicon (Si) layer 104. Such a Si layer is typically referred to as a Silicon-on-Insulator (SOI) layer 104. Here, the thickness of the SOI 104 is in the range of 0.3µm-3µm, depending on the voltage range or starting material for the process node.

Subsequent formation of a (field) oxide layer 106 covering the upper surface of the SOI layer 104 is illustrated in FIG. 3. Here, the thickness of the oxide layer 106 is in the range of 5nm-200nm. Of course, other suitable materials and/or thicknesses may be used, as would be apparent to a person skilled in the art.

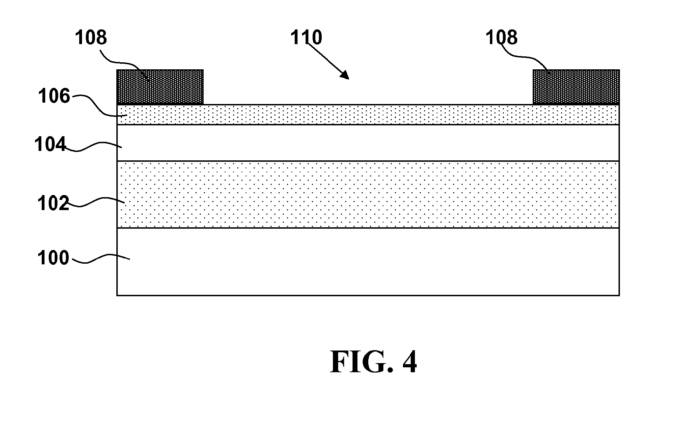

As shown in Figure 4, a silicon nitride layer 108 is formed on the upper surface of the (field) oxide layer 106 and is patterned according to known photolithographic techniques to form exposed area 110. Here, the silicon nitride layer 108 has a thickness in the range of 30nm-200nm. Other suitable materials and/or thicknesses may be used for the patterned masking layer 108, as would be apparent to a person skilled in the art.

The silicon nitride layer 108 is also referred to as a patterned masking layer 108. The nitride protects the underlying silicon from oxidizing, while allowing a thermal silicon dioxide SiO₂ layer to grow in the exposed area 110.

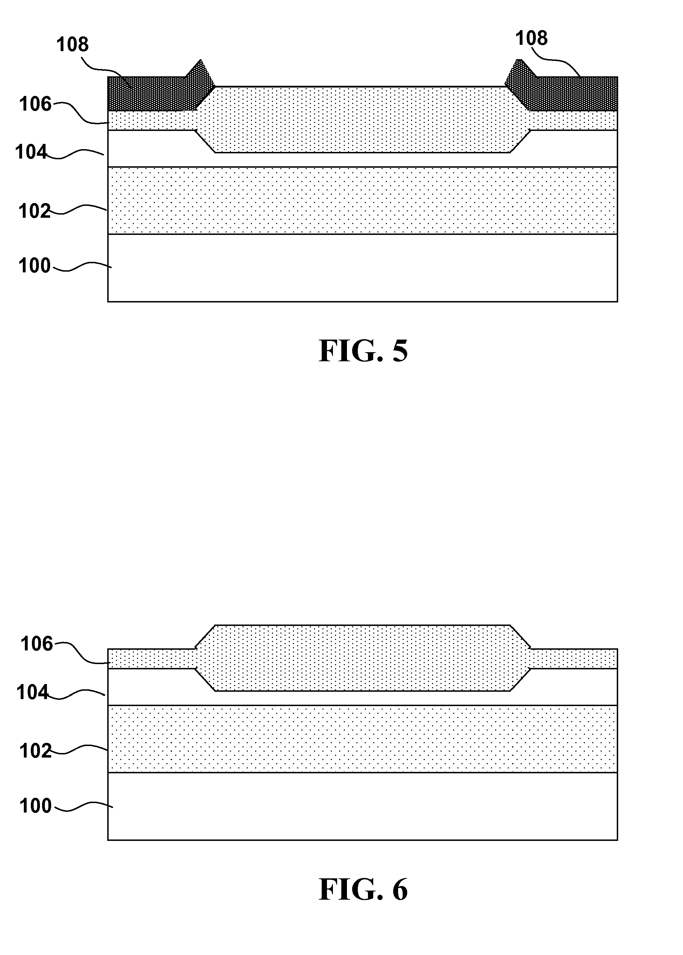

Accordingly, such selective growth of the thick (field) oxide layer 106 on a silicon layer 104 masked by the patterned silicon nitride layer 108 results in partly-recessed (field) oxide layer 106 as shown in Figure 5.

The silicon nitride layer 108 is then removed, resulting in the structure illustrated in FIG. 6.

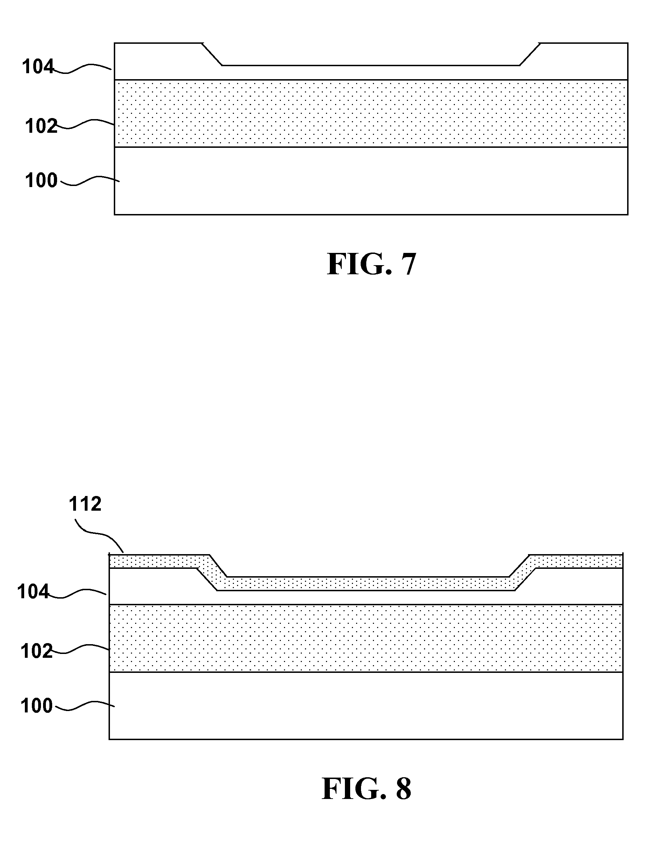

The oxide layer 106 is then also removed, resulting in the structure illustrated in FIG. 7.

Subsequent formation of a (field) oxide layer 112 covering the upper surface of the SOI layer 104 is illustrated in FIG. 8. Here, the thickness of the oxide layer 112 is in the range of 5nm-200nm. Of course, other suitable materials and/or thicknesses may be used, as would be apparent to a person skilled in the art.

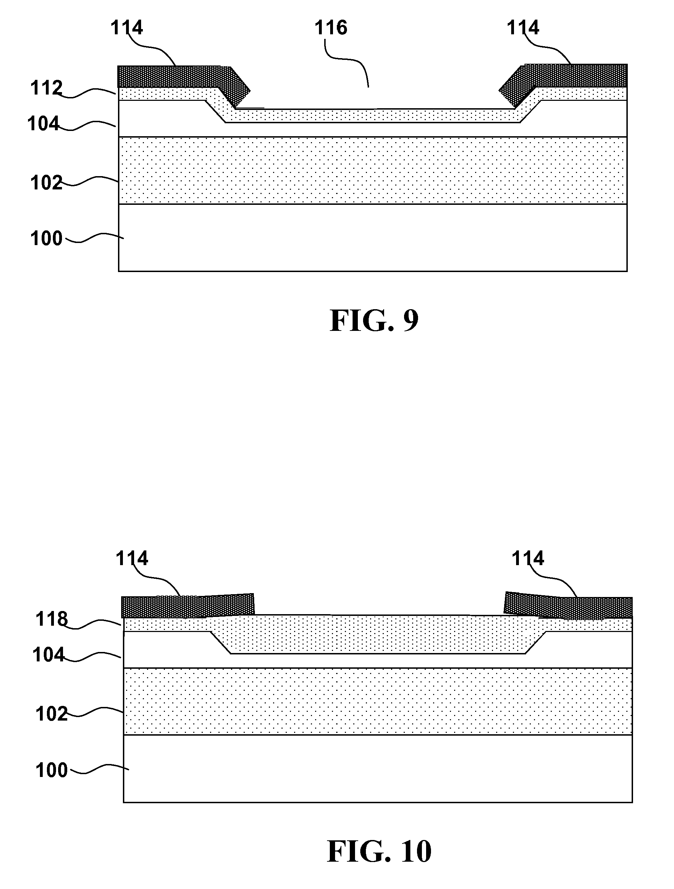

As shown in Figure 9, a masking silicon nitride layer 114 is formed on the upper surface of the (field) oxide layer 112 and is patterned according to known photolithographic techniques to form exposed area 116 above the (field) oxide layer 112. Here, the silicon nitride layer 114 has a thickness in the range of 30nm-200nm. Other suitable materials and/or thicknesses may be used for the patterned masking layer 108, as would be apparent to a person skilled in the art.

The masking silicon nitride layer 114 is referred to as a patterned masking layer 114. The nitride protects the underlying silicon from oxidizing, while allowing a thermal silicon dioxide SiO₂ layer to grow in the exposed area 116. Accordingly, such selective growth of the (field) oxide layer 112 on silicon layer 104 masked by the patterned masking silicon nitride layer 114 results in a recessed (field) oxide layer 118 as shown in Figure 10.

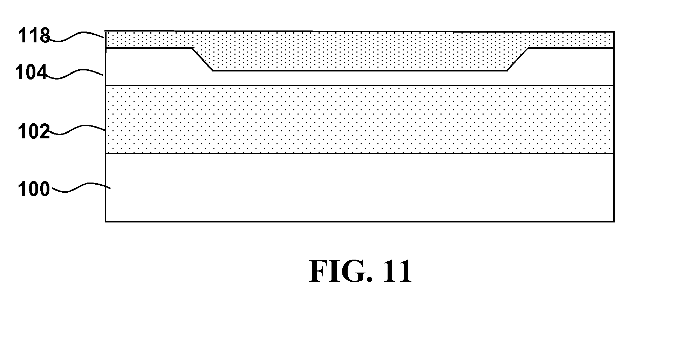

The masking silicon nitride layer 114 is then removed, resulting in the structure illustrated in FIG. 11.

The (field) oxide layer 118 is considered to be (semi) recessed because it extends downwardly into (i.e. penetrates) the surface of the SOI layer 104 causing the Si-SiO₂ (104-112) interface to occur at a lower point than the rest of the SOI layer 104 surface. In other words, the (field) oxide layer 118 is recessed under the starting surface of the SOI layer 104. As result, the thickness of the SOI layer 104 underlying the exposed area 116 (i.e. below the expanded portion of the (field) oxide layer 118) is reduced (by the amount that the oxide layer 118 has expanded downwardly into the SOI layer 104). The resultant thickness of the SOI can be more easily controlled by the selective oxide growth process than a thickness obtained by another method, such as silicon etching for example. As a consequence this resultant thickness of the SOI layer 104 can be less.

The upper surface of the (field) oxide layer 118 has a substantially flat (i.e. planar) top surface as shown in Figure 11. A flat top surface for the oxide layer 118 is beneficial since it may provide for improved lithography accuracy in subsequent lithography processing steps. Also, trench processing makes use of Chemical Mechanical Polishing (CMP) stopping layers. If the stopping layer is far above the silicon in which the trench is processed, CMP will stop at an incorrect depth. A flat top surface of the oxide layer 118 may thus help to improve the positioning accuracy of CMP stopping layers and thereby reduce CMP inaccuracies.

It will be appreciated that the insulating structure (i.e. the tapered oxide layer 118) formed using LOCOS process steps described above (with reference to Figures 2-11) is nearly fully recessed in the SOI layer 104 such that a large proportion (for example, over 50%) of the entire thickness or vertical extent of the oxide layer 118 is within the SOI layer 104. The resultant insulating structure 118 formed using the LOCOS process steps may provide for improved oxide quality and has what may be referred to as tapered oxide edge, since the thickness of the insulating structure 118 tapers (e.g. increases or decreases) from a first thickness to a second thickness along a horizontal portion of the insulating structure 118. In other words, along a horizontal segment of the insulating structure 118, the thickness of the insulating structure 118 gradually thins or narrows towards the outer edge of the structure due to tapering of the lower surface of the insulating structure 118. Thus, at a first position, the insulating structure 118 has a first thickness, and, at a second position, the insulating structure 118 has a second different thickness, wherein between the first and second positions the thickness gradually changes from the first thickness to the second thickness in a generally monotonic increasing or decreasing fashion.

Such a tapered oxide layer 118 may improve electrical field distribution and reliability. Also, the resultant insulating structure 118 has a substantially flat or planar upper surface, thereby enabling trench isolation formation using a BCD process.

Thus, Figure 11 shows a HV extension of a semiconductor device that has been formed using LOCOS processing steps. BCD process steps can be undertaken after such LOCOS process steps to construct trench isolation and well formations above the insulating structure.

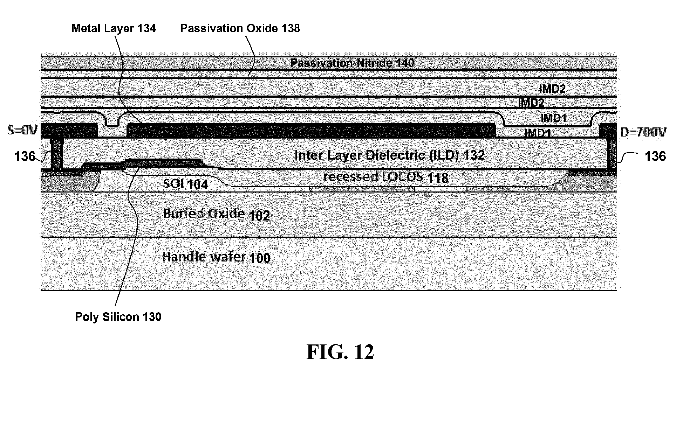

A cross section of a semiconductor transistor according to an embodiment of the invention is depicted in Figure 12. The transistor comprises a wafer substrate 100; a buried oxide insulation layer 102 formed above the substrate 100, and a Silicon-on-Insulator (SOI) layer 104 formed on the buried oxide insulation layer 102.

A tapered insulating layer 118 is formed on the SOI layer 104. The tapered insulating layer 118 has a substantially planar upper surface and is partially recessed in the SOI layer 104.

The tapered insulating layer 118 is formed using LOCOS process steps described above (with reference to Figures 2-11) and is nearly entirely recessed in the SOI layer 104 such that a large proportion (for example, over 50%) of the entire thickness or vertical extent of the insulating layer 118 is within the SOI layer 104.

From Figure 12, it will be seen that the insulating layer 118 has two areas of differing thickness. More specifically, the insulating layer 118 extends downwardly into the SOI layer 104 so that in a first area (towards the source S side of the transistor) the SOI layer 104 is thicker than the insulating layer 118 and so that in a second area (towards the drain side of the transistor) the insulating layer 118 is thicker than the SOI layer 104.

The area where the insulating layer 118 is thicker than the SOI layer 104 (in other words, the area where the insulating layer 118 is recessed to a greater extent and so thicker) is situated at the drain D side of the transistor to cater for the higher voltages that will be present in the silicon on the drain side of the transistor.

A polysilicon fieldplate 130 is formed on the source S side of the SOI layer 104 and the insulating layer 118 so that the polysilicon fieldplate 130 covers at least a part of the first area (i.e. thinner section) of the insulating layer 118.

An Inter Layer Dielectic (ILD) layer 132 is formed to cover the insulating layer 112 and the polysilicon fieldplate 130.

A metal fieldplate 134 is formed on the ILD layer 132, and the electrical contacts for the source S and drain D of the transistor are formed in the metal layer 134. The source S and drain D contacts make electrical contact with the source and drain implants of the SOI layer 104 using contact vias 136.

A plurality of Inter Metal Dielectric (IMD) layers IMD1, IMD2 are sequentially stacked on the metal layer 134, and a passivation oxide layer 138 is formed on the uppermost IMD layer IMD2. Finally, a passivation nitride layer 140 is formed on the passivation oxide layer 138.

From Figure 12, it will be seen that the transistor comprises a tapered insulating layer 118 extending laterally between the source S and drain D. The tapered insulating layer 118 has a substantially planar upper surface and is recessed in the SOI layer 104.

Accordingly, in an embodiment such as that described above with reference to Figure 12, a HV extension of a 700V MOS transistor is constructed prior to the trench isolation and well formations formed using a BCD process. This may keep any changes to LV behaviour to a minimum. The HV extension in a thin film SOI 700V device comprises a gradually doped thin SOI layer, where the thickness and doping profile of the SOI layer are preferably controlled.

In an embodiment, the MOS channel may be the same as for a low voltage device and thus created during the standard BCD process.

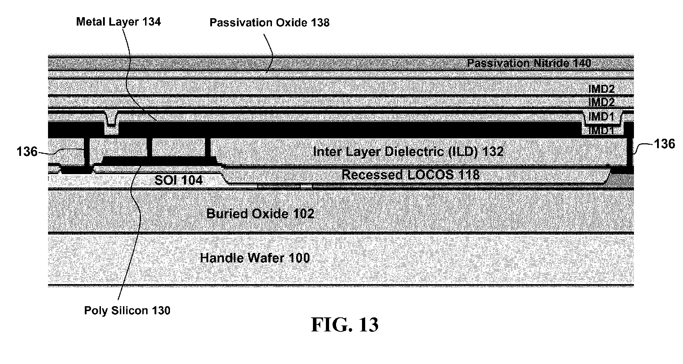

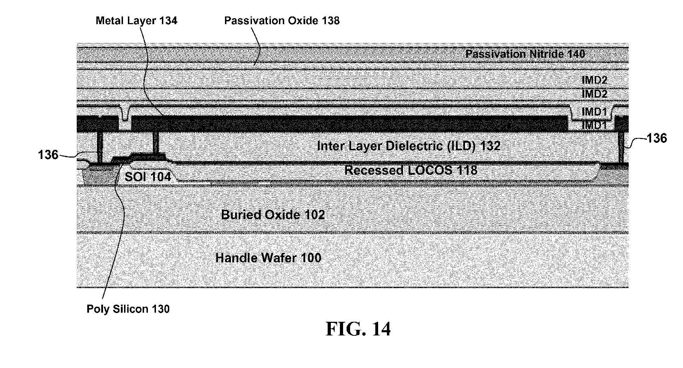

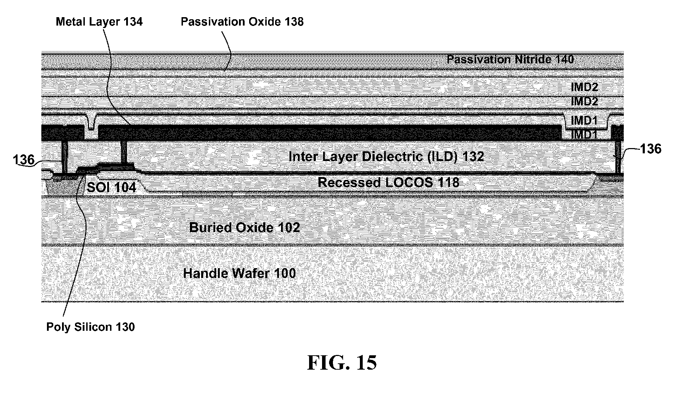

Although an embodiment described above with reference to Figure 12 relates to a HV extension of a 700V MOS transistor, other embodiments may relate to HV extensions of other semiconductor devices. For example, embodiments may provide: a HV junction gate field-effect transistor (JFET) as illustrated in Figure 13; a HV diode as illustrated in Figure 14; a Lateral Insulated-Gate Bipolar Transistor (LIGBT) as illustrated in Figure 15; or a Thyristor (or any combination thereof). Further, other embodiments may provide a HV capacitor.

Embodiments may help to reduce LV device behaviour changes by placing undertaking HV processing steps in front (i.e. before) LV process steps.

By providing no topography at the start of CMOS processing steps, embodiments may avoid lithography limitations in CMOS that may otherwise be caused by topography,

Embodiments may also provide better oxide quality than for STI-like construction.

Embodiments may exhibit less mechanical stress than for STI-like construction, thus providing less dislocations and improved reliability.

Improved electrical field distribution may be provided in a HV BCD semiconductor device manufactured according to an embodiment due to the provision of a gradual oxide taper instead of STI-like oxide step.

Various modifications will be apparent to those skilled in the art.

For example, the recess formed in the SOI layer 104 using a LOCOS process (as shown in Figure 7) may alternatively be formed using Si etching (either isotropic or anisotropic). However, it has been found that the recessed oxide layer 118 subsequently formed using LOCOS processing with this alternatively formed recess may exhibit reduced/poorer flatness and control of the oxide layer 118 depth may be more difficult.

Alternatively, the recess formed in the SOI layer 104 using a LOCOS process (as shown in Figure 7) may be created by skipping the nitride etch illustrated Figures 5-6, continuing with an oxide etch and then re-using the nitride/oxide stack that remains as the masking for the second oxidation, thereby reducing the number of masks.

## Claims

1. A semiconductor device comprising:
a silicon layer (104);
a tapered insulating layer (118) formed on the silicon layer; and
a plurality of Bipolar CMOS DMOS device layers (120) formed above the tapered insulating layer (118),
wherein the taper of the tapered insulating layer is in the lower surface of the tapered insulating layer,
and wherein the tapered insulating layer has a substantially planar upper surface and is at least partially recessed in the silicon layer.

2. The device of claim 1, wherein the semiconductor device is a high voltage semiconductor device.

3. The device of claim 1 or 2, wherein the tapered insulating layer extends downwardly into the silicon layer so that, in a first area, the silicon layer is thicker than the tapered insulating layer and so that, in a second area, the tapered insulating layer is thicker than the silicon layer.

4. The device of any preceding, further comprising:
a substrate (100); and
an insulation layer (102) formed above the substrate,
wherein the silicon layer (104) is formed on the insulation layer.

5. The device of any preceding claim, wherein the thickness of the silicon layer (104) is 3µm or less, and wherein the thickness of the tapered insulating layer (118) is in the range of 5nm-3000nm.

6. The device of any preceding claim, wherein the at least 50% of the thickness of the tapered insulating layer is recessed in the silicon layer portion.

7. The device of any preceding claim, wherein the device comprises at least first and second terminals, and wherein a silicon layer portion and a tapered insulating layer portion extend laterally between the first and second terminals.

8. The device of claim 7, wherein the silicon layer (104) is gradually doped so as to have a doping profile that varies laterally between the first and second terminals.

9. The device of claim 7 or 8, wherein the device comprises a transistor, and wherein the first terminal comprises a source of the transistor and the second terminals comprises a drain of the transistor.

10. The device of any of claims 7 to 9, further comprising:
a dielectric layer (ILD) formed on the tapered insulating layer (118); and
a metal fieldplate formed on the dielectric layer,
wherein an electrical contact for at least one of the first and second terminals is formed in the metal layer.

11. An electronic circuit comprising a semiconductor device according to any preceding claim.

12. A method of manufacturing a semiconductor device, the method comprising the steps of:
forming a tapered insulating layer on a silicon layer; and
forming a plurality of Bipolar CMOS DMOS device layers (120) above the tapered insulating layer (118),
and wherein the insulating layer is formed such that its taper is in its lower surface, the upper surface is substantially planar, and the tapered insulating layer is at least partially recessed in the silicon layer portion.

13. The method of claim 12, wherein forming a tapered insulating layer comprises:
providing a substrate layer (100);
forming an insulation layer (102) on the substrate layer;
forming a Silicon-On-Insulation, SOI, layer (104) on the insulation layer; and
forming a recessed oxide layer (118) on the SOI layer.

14. The method of claim 13, wherein the step of forming a recessed oxide layer (118) comprises:
forming an oxide layer (118) on the SOI layer (104);
covering one or more areas of the oxide layer with a masking layer (114) to leave one or more exposed areas (116) of the oxide layer;
using thermal oxidation to grow the one or more exposed areas of the oxide layer; and
planarising the upper surface of the oxide layer.

15. The method of claim 13 or 14, wherein the step of forming a recessed oxide layer (112) further comprises, prior to forming an oxide layer (118) on the SOI layer (104), undertaking the step of:
selectively growing an oxide layer (106) on the SOI layer (104) and then removing the oxide layer to form a recess in the SOI layer (104).
